Europäisches Patentamt

European Patent Office

Office européen des brevets

(11) Publication number: 0 271 202
A2

# EUROPEAN PATENT APPLICATION

(21) Application number: 87309682.0

(22) Date of filing: 02.11.87

(51) Int. Cl.⁴: G01R 13/32

The title of the invention has been amended (Guidelines for Examination in the EPO, A-III, 7.3).

(30) Priority: 10.11.86 US 928936

(43) Date of publication of application:
15.06.88 Bulletin 88/24

(84) Designated Contracting States:
DE FR GB

(71) Applicant: Hewlett-Packard Company
3000 Hanover Street
Palo Alto California 94304(US)

(72) Inventor: Landgraf, Robert M.
SR 1368, 8 Woodland Valley Drive
Woodland Park Colorado 80863(US)
Inventor: Hancock, Johnnie L.
1924 Summernight Terrace
Colorado Springs Colorado 80909(US)

(74) Representative: Colgan, Stephen James et al
CARPMAELS & RANSFORD 43 Bloomsbury
Square
London WC1A 2RA.(GB)

(54) Trigger circuit for an oscilloscope.

(57) Disclosed is a circuit for maintaining a constant effective hysteresis at the input to a trigger comparator (140) of an oscilloscope for the purpose of preventing double triggering due to false triggers. A microprocessor (205) tracks the trigger amplifier gain control (135) inversely relative to the vertical vernier amplifier gain control (125) via digital-to-analog converters (210, 220) at the input to each gain control. Such tracking serves to adjust the trigger signal inversely relative to the on-screen signal such that a constant hystersis is maintained.

EP 0 271 202 A2

FIG 6

# CHANNEL-GAIN-VERNIER-TRACKING TRIGGER HYSTERESIS FOR AN OSCILLOSCOPE

## BACKGROUND OF THE INVENTION

An oscilloscope is used to acquire, analyze and display electronic signal waveforms. The oscilloscope takes electronic signals and plots their waveforms on a cathode ray tube (CRT) display screen in units of voltage-versus-time. Conventionally, voltage amplitude is plotted along the vertical, that is, the Y axis and time is plotted along the horizontal, that is, the X axis. In the past decade, digital oscilloscopes have been developed. The basic scheme in digital oscilloscope operation is the sampling of a signal followed by analog-to-digital conversion of the voltage values of the acquired samples. The digitized information is then placed in memory and used to create the display of the signal's waveform.

A trigger level is a voltage value which the input signal must exceed before the oscilloscope begins tracking the signal with samples. The oscilloscope is said to be triggered when this level is achieved. Double triggering is an error caused by a so-called false trigger. A false trigger is noise on the input signal which may appear as a trigger voltage level to the triggering circuitry of the oscilloscope. Double triggering can result in the appearance of two superimposed and out-of-phase versions of the same signal on the oscilloscope display screen. To reduce the likelihood of double triggering, hysteresis is introduced into the trigger circuit of the oscilloscope. Fundamentally, hysteresis is just the difference between two voltage levels. The hysteresis defines a first voltage level, known as the arm point, and a second higher voltage level, known as the fire point. Ideally, the input signal must first exceed the arm point and then the fire point, in sequence, in order for the trigger circuit to detect a true trigger. For instance, the arm point can enable a trigger comparator and the fire point can cause an output from the trigger comparator, signalling a true trigger. Generally, the hysteresis is set such that typical signal noise and internal instrument noise will not cause a false trigger. The size of the hysteresis determines the minimum signal necessary to produce a triggered waveform on the oscilloscope display screen.

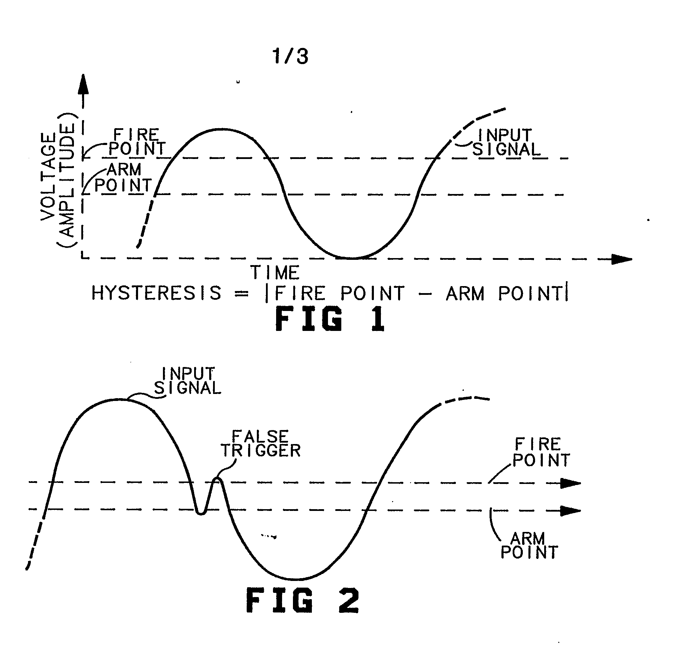

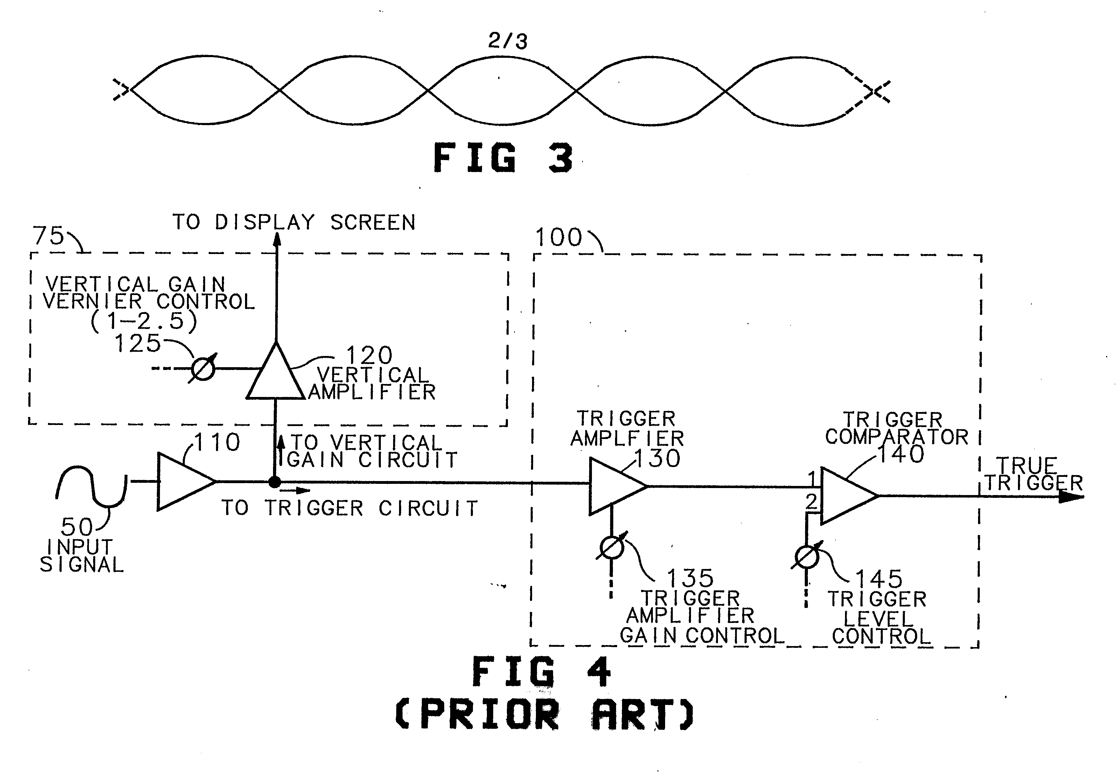

Figure 1 shows an input signal having an arm point and a fire point defining the triggering hyteresis, where the hysteresis is the fire point value minus the arm point value. Figure 2 shows an input signal having a false trigger due to noise on the signal. Figure 3 shows an example of the double trigger display which is due to a false trigger.

Figure 4 shows a typical oscilloscope circuit wherein input signal 50 is buffered by buffer amplifier 110 and then sent to both a vertical gain vernier circuit 75 and trigger circuit 100. Vertical gain circuit 75 comprises a vertical amplifier 120 which controls the gain vernier along the vertical axis, that is, the voltage ampltiude axis, of the oscilloscope display screen. Vertical amplifier 120 has a user-adjustable vertical gain vernier control 125, typically having a range of 1 through 2.5. Trigger circuit 100 comprises a trigger amplifier 130 and a trigger comparator 140. One input to trigger comparator 140 is the output of trigger amplifier 130. The other input to trigger comparator 140 is a user-adjustable trigger level input having trigger level offset control 145. Ideally, the trigger level input defines the voltage level at which the oscilloscope will trigger. Trigger comparator 140 will produce an output given a predetermined difference between its inputs. Ideally, the output of trigger comparator 140 indicates a true trigger.

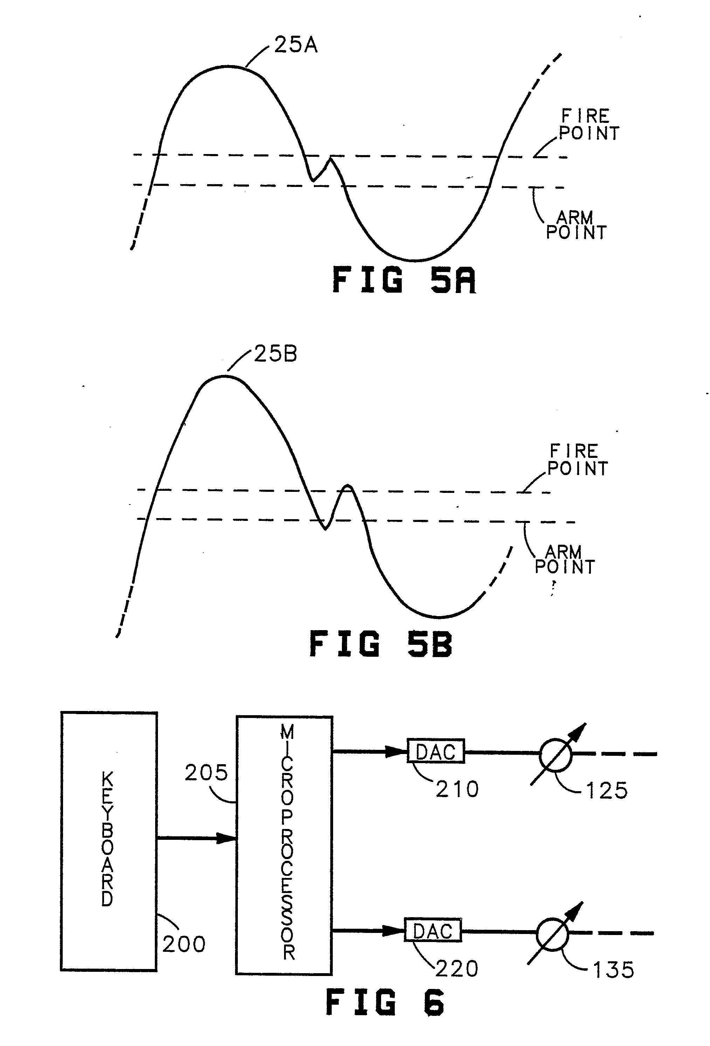

Typically, trigger comparator 140 has a fixed hysteresis. Typically, trigger amplifier 130 has a gain control 135. Varying the gain of trigger amplifier 130 varies the input to trigger comparator 140 and consequently the effective hysteresis is varied. For instance, with a fixed hysteresis on trigger comparator 140, a doubling of the output of trigger amp 130 will halve the hysteresis and a halving of the output of trigger amplifier 130 will double the hysteresis. This variation in the effective hysteresis can be seen in Figures 5A and 5B. In Figure 5A, input signal 25A has a noise spike on its down slope but the size of the hysteresis prevents a false trigger. In Figure 25B, input signal 25B has twice the gain of input signal 25A of Figure 5A. Although the hysteresis is the same in both Figures 5A and 5B, doubling the gain of signal 25A to produce signal 25B also doubles the size of the noise spike which then is big enough to cause a false trigger. Therefore, doubling the signal effectively halves the hysteresis and halving the signal would likewise effectively double the hysteresis.

To prevent the problem of variation in the effective size of the hysteresis, the gain control 135 of trigger amplifier 130 is typically fixed when the instrument in calibrated. However, fixing the trigger amplifier gain has negative side-effects. To keep a signal spanned across a constant number of divisions on the display screen as the vertical gain 125 is adjusted from X1 to X2.5, the input to trigger amplifier 130 would also have to vary from X1 to X2.5, causing the hysteresis to vary inversely, requiring trigger level control 145 to have sufficient range to cover the largest signal at the lowest vertical gain setting as well as sufficient resolution to cover the smallest signal at the largest vertical gain setting. The slew rate demands through the trigger circuit path would also be X2.5 higher than if the signal range was fixed.

SUMMARY OF THE INVENTION

The present invention provides for an effective constant hysteresis through a micro-processor controlled tracking of the trigger amplifier gain control and the vertical amplifier gain control. A micro-processor controls the tracking of the two gain controls via digital-to-analog converters (DAC) which are connected to the input of each gain control. The tracking of the two gain controls allows for an effectively constant voltage range input to the trigger comparator relative to the on-screen vertical range of the signal. Hence, a four-division signal on screen at a vertical gain setting of X1 will give the same input to the trigger comparator as a four-division signal at X2.5 vertical gain. Such tracking provides several benefits. Throughout the range of vertical gain, noise rejection will be constant; the effective hysteresis will remain constant; the minimum signal required for triggering will remain constant; the required trigger level resolution will remain constant; and the slew rate demands of the trigger circuit will be reduced.

BRIEF DESCRIPTION OF THE DRAWINGS

Figure 1 shows an input signal having an arm point and a fire point defining trigger hysteresis.

Figure 2 shows an input signal having a false trigger.

Figure 3 shows an example of double trigger due to a false trigger.

Figure 4 shows a typical oscilloscope circuit having an input signal buffer, a vertical gain vernier circuit and a trigger circuit.

Figures 5A and 5B show variation in the effective hysteresis due to gain changes in a signal.

Figure 6 shows a circuit for tracking the trigger amplifier gain control of Figure 4 to the vertical amplifier gain control of Figure 4 via a microprocessor.

DESCRIPTION OF THE PREFERRED EMBODIMENT

Figure 6 shows a circuit for tracking the trigger amplifier gain control 135 to the vertical amplifier gain control 125. The oscilloscope user can enter vertical gain control commands at keyboard 200. Microprocessor 205 then issues predetermined signals to vertical gain control 125 via digital-to-analog convertor (DAC) 210 and to trigger gain control 135 via DAC 220. The tracking by microporcessor 205 serves to inversely adjust trigger amplifier gain control 135 relative to vertical gain control 125 such that the effective hysteresis seen by trigger comparator 140 remains constant.

**Claims**

1. a tracking circuit (Fig. 6) for an oscilloscope, said tracking circuit to be used for keeping a constant effective hysteresis at the input of a trigger comparator (140), said comparator to be used to indicate a true trigger for said oscilloscope, comprising:

a trigger circuit (100) having a trigger signal amplifier (130), said trigger signal amplfier having a trigger amplifier gain control (135), and alos having said trigger comparator, said comparator having two inputs, one input being the output of said trigger amplifier and the other input being a user-adjustable trigger level control (145);

a vertical gain vernier circuit (75) having a vertical gain amplifier 120), said amplifier having a vertical gain control (125);

a plurality of digital-to-analog convertors (DAC) (210, 220), wherein one DAC is connected to the input of the vertical gain control and another DAC is connected to the input of the trigger amplifier gain control; and

a microprocessor (205), said microprocessor to be used to control the inputs to the DACs at the vertical gain and trigger amplifier gain control inputs such that the gain of the trigger amplifier is inversely tracked to the gain of the vertical gain amplifier.

VOLTAGE (AMPLITUDE)

FIRE POINT

ARM POINT

INPUT SIGNAL

TIME

HYSTERESIS = |FIRE POINT − ARM POINT|

# FIG 1

INPUT SIGNAL

FALSE TRIGGER

FIRE POINT

ARM POINT

# FIG 2

# FIG 3

TO DISPLAY SCREEN

75

VERTICAL GAIN
VERNIER CONTROL
(1-2.5)
125

120
VERTICAL
AMPLIFIER

100

110

50
INPUT
SIGNAL

TO VERTICAL
GAIN CIRCUIT

TO TRIGGER CIRCUIT

TRIGGER
AMPLFIER
130

135
TRIGGER
AMPLIFIER
GAIN CONTROL

TRIGGER
COMPARATOR
140

1
2

145
TRIGGER
LEVEL
CONTROL

TRUE
TRIGGER

0 271 202

# FIG 4
# (PRIOR ART)

25A

FIRE
POINT

ARM
POINT

# FIG 5A

25B

FIRE
POINT

ARM
POINT

# FIG 5B

KEYBOARD

MICROPROCESSOR

DAC

DAC

205

200

210

220

125

135

# FIG 6